# EUROPEAN PATENT APPLICATION

(11) **EP 4 382 631 A1**
(43) Date of publication of application: **12.06.2024**
(21) Application number: 22920114.0
(22) Date of filing: 30.12.2022
(51) Int. Cl.: C23C 14/04, C23C 14/56

(54) **COATING APPARATUS**

(30) Priority: 13.01.2022 CN 202210037973
(71) Applicant: Contemporary Amperex Technology Co., Limited, Ningde City, Fujian 352100 (CN)
(72) Inventor: LI, Keqiang, Ningde City, Fujian 352100 (CN); LIU, Xiaosong, Ningde City, Fujian 352100 (CN); WU, Zhiyang, Ningde City, Fujian 352100 (CN); LU, Yi, Ningde City, Fujian 352100 (CN)
(74) Representative: Ziebig Hengelhaupt Intellectual Property Attorneys Patentanwaltskanzlei PartGmbB
(86) International application number: PCT/CN2022/144267
(87) International publication number: WO 2023/134484

(57) **Abstract**

Embodiments of the present application provide a coating apparatus that can form a high-accuracy pattern coating on a base film, thereby improving the performance of components including the base film (such as current collectors). The coating apparatus includes: a coating-resistance pattern unit (210) configured to form a pattern composed of a coating-resistance substance on a partial area of the surface of a base film (230), where the coating-resistance substance is used to restrict metal vapor from forming a coating; and a coating unit (220) configured to apply the metal vapor to the base film (230) with the pattern, so as to form a metal coating on the area of the surface of the base film (230) where the coating-resistance substance is not provided.

## Description

### Cross-Reference to Related Application

The present application claims priority to Chinese patent application 202210037973.7 filed on Jan. 13, 2022 and entitled "COATING APPARATUS", which is incorporated herein by reference in its entirety.

### Technical Field

The present application relates to the field of coating technology, and in particular to a coating apparatus.

### Background

Energy conservation and emission reduction are the keys to the sustainable development of the automobile industry. In view of this, electric vehicles have become an important part of the sustainable development of the automotive industry due to their advantages of energy conservation and environmental protection. For electric vehicles, battery technology is an important factor related to their development.

As an indispensable part of the battery, the current collector plays an extremely important role, and its performance affects the performance of the battery. Therefore, it is an urgent problem to be solved to improve the performance of current collectors effectively.

### Summary of the Invention

Embodiments of the present application provide a coating apparatus that can form a high-accuracy patterned coating on a base film, thereby improving the performance of components including the base film (such as current collectors).

In a first aspect, a coating apparatus is provided, including: a coating-resistance pattern unit configured to form a pattern composed of a coating-resistance substance on a partial area of the surface of a base film, where the coating-resistance substance is used to restrict metal vapor from forming a coating; and a coating unit configured to apply the metal vapor to the base film with the pattern, so as to form a metal coating on the area of the surface of the base film where the coating-resistance substance is not provided.

The above technical solution uses a regional coating resistance method when preparing a component including a base film, that is, the coating-resistance pattern unit forms a pattern composed of a coating-resistance substance on a partial area of the surface of the base film. During the coating process of the coating unit, the area of coating-resistance substance on the surface of the base film cannot be coated, and areas other than the area of coating-resistance substance are positively coated, thereby forming a high-accuracy patterned coating, which is beneficial to improving the performance of components including the base film.

In some possible implementations, the coating-resistance pattern unit includes: a heating roller configured to heat the coating-resistance substance; a pattern roller with the pattern provided on the surface to print the heated coating-resistance substance on the base film in the shape of the pattern when the base film passes over the pattern roller, so as to form the pattern on the partial area of the surface of the base film.

In the above technical solution, the coating-resistance pattern unit includes a heating roller configured to heat the coating-resistance substance, so that the heated coating-resistance substance can be printed on the base film more easily. In addition, the coating-resistance pattern unit includes a pattern roller with a pattern provided on the surface. In this way, when the base film passes over the pattern roller, the heated coating-resistance substance can be printed on the base film in the pattern on the pattern roller, so that the pattern formed on the partial area of the surface of the base film is identical with the required pattern, thereby improving the accuracy of the pattern formed on the surface of the base film.

In some possible implementations, the coating-resistance pattern unit further includes: a bottom roller arranged side by side with the pattern roller on two sides of the base film, where when the base film, passes between the pattern roller and the bottom roller, the coating-resistance substance on the pattern roller is formed on the partial area of the surface of the base film in the shape of the pattern under the pressure between the pattern roller and the bottom roller.

In the above technical solution, the coating-resistance pattern unit includes a bottom roller arranged side by side with the pattern roller on two sides of the base film, so that the pattern roller and the bottom roller can exert pressure on each other. As such, when the base film passes between the pattern roller and the bottom roller, the pressure between the pattern roller and the bottom roller can cause the coating-resistance substance on the pattern roller to be formed as much as possible on the surface of the base film to ensure the accuracy of the coating.

In some possible implementations, the coating-resistance pattern unit further includes: an anilox roller arranged between the heating roller and the pattern roller, where the surface of the anilox roller is provided with a plurality of pits to store the heated coating-resistance substance, and the anilox roller is used to transfer the stored heated coating-resistance substance to the pattern roller.

In the above technical solution, by arranging an anilox roller between the heating roller and the pattern roller, the heated coating-resistance substance can be evenly stored in the plurality of pits on the surface of the anilox roller. In this way, when the anilox roller transfers the coating-resistance substance to the pattern roller, it can also transfer the coating-resistance substance to the pattern roller evenly, which avoids the case where part of the surface of the pattern roller receives more coating-resistance substance and part of the surface receives less or even no coating-resistance substance, thereby ensuring the accuracy of the pattern printed on the base film.

In some possible implementations, the pattern roller is a roller made of rubber.

Since the pattern processed on the rubber surface has high accuracy, providing the pattern roller as a roller made of rubber can improve the accuracy of the pattern on the pattern roller.

In some possible implementations, a cooling unit is further included to cool the base film with the pattern after the pattern is formed on the partial area of the surface of the base film.

By providing a cooling unit, when the metal coating has a large thickness and the base film endures a high amount of heat, the cooling unit can cool the base film, thereby avoiding the problem of deformation of the base film at high temperatures, and effectively ensuring the normal progress of the coating and subsequent processes.

In some possible implementations, the cooling unit includes: a cold drum configured to transfer and cool the base film with the pattern, where the cold drum is provided as a hollow structure, and the hollow structure contains a cooling liquid to cool the base film with the pattern in the process of circulation.

The above technical solution uses a cold drum to cool the base film and is simple to implement. Moreover, the cold drum is provided with a circulating cooling liquid, and better cooling effect can be achieved through the circulation of the cooling liquid. That is, the embodiments of the present application can achieve better cooling effect in a simpler manner.

In some possible implementations, the surface of the cold drum is coated with an insulating material.

The above technical solution can avoid the problem of electric conduction between the cold drum and the base film by coating the surface of the cold drum with an insulating material, thereby effectively ensuring the normal progress of the coating.

In some possible implementations, the thickness of the insulating material is 30um-200um.

In some possible implementations, the cooling unit further includes: a bias roller arranged downstream of the cold drum in the transferring direction of the base film to adsorb the base film with the pattern on the surface of the cold drum.

The above technical solution strengthens the adhesion between the base film and the cold drum by providing the bias roller, thereby improving the cooling effect of the coolant in the cold drum on the base film. That is, the above technical solution effectively enhances the cooling effect on the base film through the cooperation of the cold drum and the bias roller.

In some possible implementations, the cold drum is grounded and the bias roller is connected to a negative voltage.

In some possible implementations, the cooling unit further includes: a gas cooling tube including a heat-conducting medium which is introduced by the gas cooling tube through a gas port to a position between the cold drum and the base film with the pattern, so that the heat-conducting medium cools the base film with the pattern.

In the above technical solution, the cooling unit is provided with a gas cooling tube in addition to the cold drum, that is, the base film is cooled jointly by the cold drum and the gas cooling tube, which can further enhance the cooling effect on the base film.

In some possible implementations, the heat-conducting medium is an inert gas.

In the above technical solution, since the inert gas is relatively cheap, using the inert gas for cooling can effectively cool the base film at a lower cost.

In some possible implementations, the coating unit includes a vacuum coating mechanism configured to deliver metal vapor toward the base film on the cold drum.

In some possible implementations, the coating-resistance substance is silicone oil.

According to the above technical solution, when the base film is in a high temperature state, if the surface of the base film is coated with silicone oil, the silicone oil will not melt at high temperature, and a metal coating will still not be formed at the position on the surface of the base film that is coated with the silicone oil. Therefore, using silicone oil as a coating-resistance substance is beneficial to improving the accuracy of the coating.

In some possible implementations, the thickness of the metal coating is lum-3um.

In the above technical solution, the thickness of the metal coating is set to 1um-3um. As such, the resistance of the components prepared by the coating apparatus can be reduced.

In some possible implementations, the base film is a polyethylene terephthalate PET film.

In the above technical solution, PET has high thermal stability. Therefore, providing the base film as a PET film can improve the thermal stability of the base film. Furthermore, weight reduction is achieved through PET, thereby achieving lightweight components prepared by the coating apparatus, thereby increasing the energy density.

In some possible implementations, the metal vapor is copper vapor or aluminum vapor.

In the above technical solution, the metal vapor is copper vapor or aluminum vapor, so that if the component prepared by the coating apparatus is a current collector, the purpose of improving the performance of the current collector can be achieved and the performance of the battery including the current collector can be further improved.

### Description of Drawings

In order to illustrate the technical solutions of the embodiments of the present application more clearly, the drawings required in the embodiments of the present application will be briefly introduced below. Obviously, the drawings described below represent only some embodiments of the present application. For those of ordinary skill in the art, other drawings can also be obtained according to the drawings without any creative effort.
Fig. 1 is a schematic structural diagram of a vehicle disclosed in an embodiment of the present application.
Fig. 2 is a schematic structural diagram of a coating apparatus according to an embodiment of the present application.
Fig. 3 is a schematic structural diagram of another coating apparatus according to an embodiment of the present application.
Fig. 4 is a schematic structural diagram of yet another coating apparatus according to an embodiment of the present application.
Fig. 5 is a schematic structural diagram of still another coating apparatus according to an embodiment of the present application.

The drawings are not drawn to actual scale.

### Detailed Description

The implementations of the present application are to be described in further detail below with reference to the drawings and embodiments. The following detailed description of the embodiments and the drawings are used to illustrate the principles of the present application by way of example, but should not be used to limit the scope of the present application, that is, the present application is not limited to the described embodiments.

In the description of the present application, it should be noted that, unless otherwise stated, "a plurality of" means two or more; the orientation or positional relationships indicated by the terms "upper", "lower", "left", "right", "inner" and "outer" are only for facilitating the description of the present application and simplifying the description, rather than indicating or implying that the apparatus or element referred to must have a particular orientation or be constructed and operated in a particular orientation, and therefore shall not be construed as limiting the present application. In addition, the terms "first", "second" and "third" are used for descriptive purposes only, and shall not be construed as indicating or implying relative importance. "Perpendicular" is not strictly perpendicular, but rather within the allowed margin of tolerance. "Parallel" is not strictly parallel, but rather within the allowed margin of tolerance.

The directional words appearing in the following description are the directions shown in the figures and do not limit the specific structure of the present application. In the description of the present application, it should also be noted that the terms "mounting", "connecting", and "connection" should be understood in a broad sense, unless otherwise explicitly specified or defined. For example, it may be a fixed connection, a detachable connection, or an integrated connection; and it may be a direct connection or an indirect connection through an intermediate medium. For those of ordinary skill in the art, the specific meanings of the above terms in the present application may be understood according to specific circumstances.

In the present application, the term "and/or" is only an associative relationship for describing associated objects, indicating that there may be three relationships, for example A and/or B may represent three situations: A alone, both A and B, and B alone. In addition, the character "/" in the present application generally means that the associated objects before and after it are in an "or" relationship.

Unless otherwise defined, all technical and scientific terms used in the present application have the same meaning as commonly understood by those skilled in the art belonging to the technical field of the present application; the terms used in specification of the present application are intended only for the purpose of describing specific embodiments and are not intended to limit the present application; the terms "including" and "having" and any variations thereof in the specification and the claims of the present application and in the description of drawings above are intended to cover non-exclusive inclusion. In the specification, claims, and accompanying drawings above of the present application, the terms such as "first" and "second" are intended to distinguish between different objects rather than describe a particular order or primary-subordinate relationship.

Reference in the present application to "an embodiment" means that a particular feature, structure, or characteristic described in connection with the embodiment can be included in at least one embodiment of the present application. The appearance of this phrase in various places in the specification does not necessarily refer to the same embodiment, nor is it a separate or alternative embodiment that is mutually exclusive with other embodiments. It is understood explicitly and implicitly by those skilled in the art that the embodiments described in the present application can be combined with other embodiments.

Although the present application has been described with reference to the preferred embodiments, various improvements can be made thereto and components thereof can be replaced with equivalents without departing from the scope of the present application. In particular, the technical features mentioned in the various embodiments can be combined in any manner as long as there is no structural conflict. The present application is not limited to the specific embodiments disclosed herein, but rather includes all technical solutions falling within the scope of the claims.

In recent years, batteries, as a major power equipment, have been widely used in electric vehicles, military equipment, aerospace and other fields.

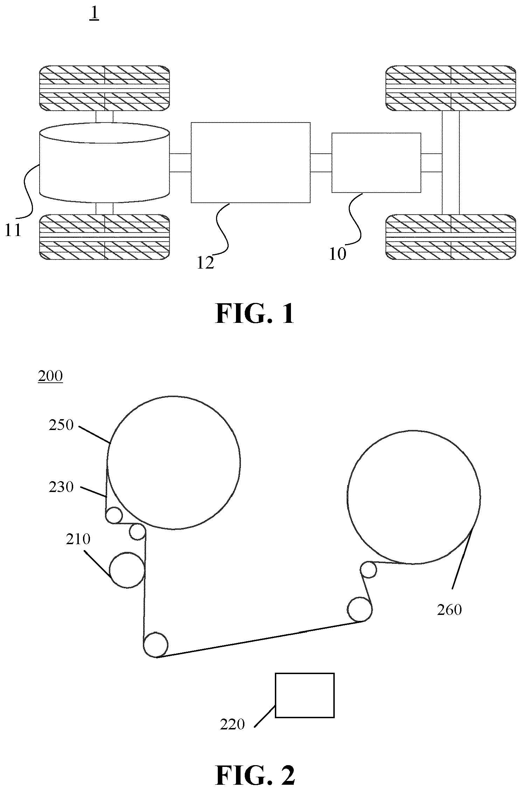

For example, Fig. 1 shows a schematic structural diagram of a vehicle 1 according to an embodiment of the application. The vehicle 1 may be a fuel vehicle, a gas vehicle, or a new energy vehicle, and the new energy vehicle may be an all-electric vehicle, a hybrid electric vehicle, an extended range electric vehicle, or the like. A motor 40, a controller 30 and a battery 10 may be provided inside the vehicle 1, and the controller 30 is configured to control the battery 10 to supply power to the motor 40. For example, the battery 10 may be arranged at the bottom or the head or the tail of the vehicle 1. The battery 10 may be configured to supply power to the vehicle 1. For example, the battery 10 may be used as an operating power source of the vehicle 1, which is used for a circuit system of the vehicle 1, e.g., for operation power demands of the vehicle 1 during starting, navigation and running. In another embodiment of the present application, the battery 10 can not only be used as the operating power source of the vehicle 1, but also as a driving power source of the vehicle 1 to provide driving power for the vehicle 1 instead of or partially instead of fuel or natural gas.

In the embodiments of the present application, the term battery refers to a physical module including one or more battery cells to provide electric energy. For example, the battery mentioned in the present application may include a battery module, a battery pack, or the like. The battery generally includes a box body for encapsulating one or more battery cells. The box body can prevent liquids or other foreign matters from affecting the charging or discharging of the battery cells.

In the present application, the battery cell may include a lithium-ion secondary battery, a lithium-ion primary battery, a lithium-sulfur battery, a sodium-lithium-ion battery, a sodium-ion battery, a magnesium-ion battery, or the like, which will not be limited in the embodiments of the present application. Generally, a battery cell may also be called a cell core.

The battery cell includes an electrode assembly and an electrolyte, the electrode assembly being composed of a positive electrode sheet, a negative electrode sheet and a separator. The battery cell operates mainly relying on movement of metal ions between the positive electrode sheet and the negative electrode sheet. The positive electrode sheet includes a positive electrode current collector and a positive electrode active material layer. The positive electrode active material layer is coated on the surface of the positive electrode current collector, the part of the positive electrode current collector not coated with the positive electrode active material layer protrudes from the part of the positive electrode current collector already coated with the positive electrode active material layer, and the part of the positive electrode current collector not coated with the positive electrode active material layer serves as a positive electrode tab. Taking a lithium-ion battery as an example, the material of the positive electrode current collector may be aluminum, and the positive electrode active material may be lithium cobalt oxide, lithium iron phosphate, ternary lithium, lithium manganate, or the like. The negative electrode sheet includes a negative electrode current collector and a negative electrode active material layer. The negative electrode active material layer is coated on the surface of the negative electrode current collector, the part of the negative electrode current collector not coated with the negative electrode active material layer protrudes from the part of the negative electrode current collector already coated with the negative electrode active material layer, and the part of the negative electrode current collector not coated with the negative electrode active material layer serves as a negative electrode tab. The material of the negative electrode current collector may be copper, and the negative electrode active material may be carbon, silicon, or the like. In order to ensure that no fusing occurs when a large current passes, there are a plurality of positive electrode tabs which are stacked together, and there are a plurality of negative electrode tabs which are stacked together. The material of the separator may be polypropylene (PP), polyethylene (PE) or the like.

At present, consumers have higher and higher requirements for battery performance. As an indispensable part of the battery, the current collector plays an extremely important role. Its performance significantly affects the performance of the battery.

In view of this, embodiments of the present application propose a coating apparatus that can form a high-accuracy patterned coating on a base film, thereby improving the performance of the current collector.

Fig. 2 is a schematic structural diagram of a coating apparatus 200 according to an embodiment of the present application. As shown in Fig. 2, the coating apparatus 200 may include: a coating-resistance pattern unit 210 and a coating unit 220.

The coating-resistance pattern unit 210 is configured to form a pattern composed of a resistance substance on a partial area of the surface of the base film 230, and the resistance substance is used to restrict metal vapor from forming a coating. The coating unit 220 is configured to apply metal vapor to the base film 230 with the pattern, so as to form a metal coating on the area of the surface of the base film 230 where the coating-resistance substance is not provided.

The embodiments of the present application use a regional resistance method when preparing a component including the base film 230, that is, the coating-resistance pattern unit 210 forms a pattern composed of a coating-resistance substance on a partial area of the surface of the base film 230. During the coating process of the coating unit 220, the area of coating-resistance substance on the surface of the base film 230 cannot be coated, and areas other than the area of coating-resistance substance are positively coated, thereby forming a high-accuracy patterned coating, which is beneficial to improving the performance of the component including the base film 230.

Optionally, the metal vapor may be copper vapor or aluminum vapor. At this time, the coating apparatus 200 can be used to prepare the current collector. Therefore, the embodiments of the present application achieve the purpose of improving the performance of the current collector, and further improve the performance of the battery including the current collector.

Of course, the coating apparatus 200 can also be used to prepare other components. For convenience of description, the following description takes the coating apparatus 200 used to prepare a current collector as an example. However, it should be understood that the embodiments of the present application are not limited to this.

As mentioned above, the material of the traditional positive electrode current collector is aluminum foil, and the material of the traditional negative electrode current collector is copper foil. Considering that high energy density, lightweight and flexibility of batteries are increasingly becoming people's goals, the density of copper is 8.9g/cm3 and the density of aluminum is 2.79g/cm3, the total mass of the positive and negative electrode current collectors accounts for about 14%-18% of the total mass of the battery, so it cannot satisfy the pursuit of high energy density and lightweight of batteries.

Therefore, the coating apparatus 200 can be used to prepare the composite current collector. The base film 230 of the composite current collector may be a plastic film, and the upper and lower surfaces of the plastic film are respectively coated with metal layers. The weight of the current collector is reduced through the plastic film, thereby effectively increasing the energy density of the battery. In addition, the plastic film as the base film 230 has strong tensile strength, which makes the window of tension, pressure, etc. in the preparation process larger. Therefore, the coating apparatus 200 can use higher pressure to achieve greater compaction density and improve the preparation capability.

Optionally, the plastic film can be oriented polypropylene (OPP) plastic, polyimide (PI) plastic, polyethylene glycol terephthalate (PET) plastic, cast polypropylene (CPP) plastic or polyvinyl chloride (PVC) plastic, as well as one or more of their derivatives, cross-linked products and copolymers.

Compared with other plastic films, PET has higher thermal stability. Therefore, the base film 230 according to the embodiments of the present application may be PET to improve the thermal stability of the base film 230.

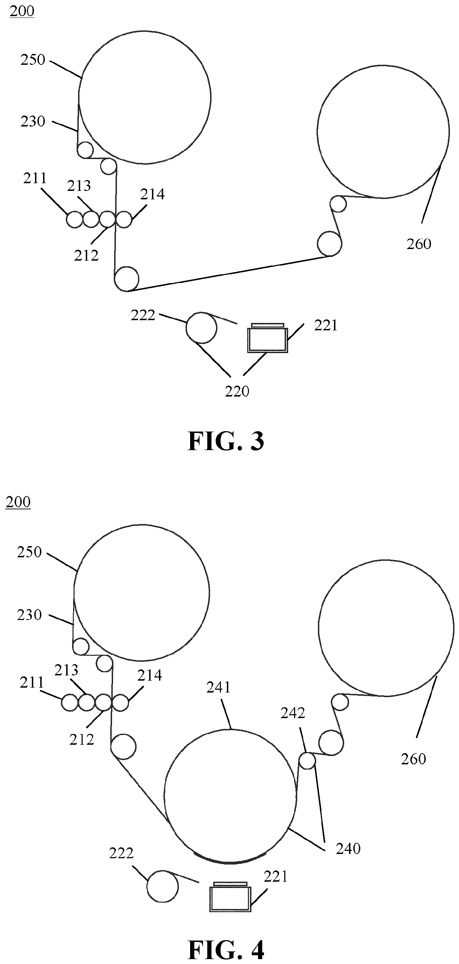

In some embodiments, as shown in Fig. 3, the coating unit 220 may include a vacuum coating mechanism 221 for applying metal vapor to the base film 230 with the pattern in a vacuum environment. For example, the vacuum coating mechanism 221 can be arranged in a chamber, and then a vacuum pump is used to evacuate the air in the chamber, so that the chamber is in a vacuum environment, in such a manner that the vacuum coating mechanism 221 can perform vacuum coating on the base film 230. The vacuum degree can be controlled by the amount of air evacuated by the vacuum pump, and can be adjusted according to needs. For example, the vacuum degree may be (1~7)*10-2Pa.

Alternatively, the vacuum coating mechanism 221 may be an evaporation source. Specifically, when the coating apparatus 200 is used to prepare a positive electrode current collector, the evaporation source may be an aluminum evaporation source, and the metal vapor may be aluminum vapor; and when the coating apparatus 200 is used to prepare a negative electrode current collector, the evaporation source may be a copper evaporation source, and the metal vapor may be copper vapor.

The evaporation source may be a metal wire, or may be a metal block or other structure, which is not specifically limited in the embodiments of the present application. If the evaporation source is a metal wire, such as an aluminum metal layer, as shown again in Fig. 3, the coating unit 220 may also include a wire feeding mechanism 222. That is, the coating unit 220 includes a vacuum coating mechanism 221 and a wire feeding mechanism 222. The wire feeding mechanism 222 is used to continuously deliver the metal wire, so that the vacuum coating mechanism 221 delivers metal vapor toward the base film 230.

When the evaporation source is a metal wire, the metal wire has high material utilization rate and is easy to clean.

It should be noted that in the embodiments of the present application, the thickness of the metal coating can be determined according to specific application scenarios. For example, if, from an electrical perspective, the resistance of the current collector needs to be smaller, then the metal coating can be slightly thicker, for example, the thickness of the metal coating is 1um-3um. As such, the resistance of the current collector can be reduced.

Optionally, the embodiments of the present application do not specifically limit the coating-resistance substance. Any material that can be used to limit the formation of a coating by metal vapor can be understood as the coating-resistance substance in the embodiments of the present application. For example, since when the base film 230 is in a high temperature state, if the surface of the base film 230 is coated with silicone oil, the silicone oil will not melt in high-temperature state, and a metal coating will still not be formed at the position on the surface of the base film 230 that is coated with silicone oil, which is beneficial to improving the accuracy of the coating. Therefore, the coating-resistance substance may be silicone oil.

In some embodiments, referring again to Fig. 3, the coating-resistance pattern unit 210 may include a heating roller 211 and a pattern roller 212. The heating roller 211 is used to heat the coating-resistance substance. The pattern roller 212 is provided with a pattern on the surface and is used to print the heated coating-resistance substance on the base film 230 in the shape of the pattern when the base film 230 passes over the pattern roller 212, so as to form a pattern on a partial area of the surface of the base film 230.

Optionally, the heating roller 211 may heat the coating-resistance substance in vacuum. For example, the heating roller 221 can heat the coating-resistance substance to 80°C-120°C in a vacuum environment.

Optionally, after the heating roller 211 heats the coating-resistance substance, the heated coating-resistance substance can be transferred to the pattern roller 212 by evaporation.

Optionally, the heating roller 211 and the pattern roller 212 may be provided on the same side of the base film 230. For example, referring again to Fig. 3, the heating roller 211 and the pattern roller 212 may be arranged side by side on the same side of the base film 230. Of course, the heating roller 211 may also be arranged upstream of the pattern roller 212. Alternatively, the heating roller 211 and the pattern roller 212 may be arranged on two sides of the base film 230 respectively.

Optionally, the pattern roller 212 may be a roller made of flexible material. As an example, the flexible material may be rubber. Since the accuracy of the pattern processed on the rubber surface is high, providing the pattern roller 212 as a roller made of rubber can improve the accuracy of the pattern on the pattern roller 212.

As an example, the range of accuracy of the pattern provided on the surface of the pattern roller 212 may be 10um-500um. For example, it may be 50um-500um.

In the above technical solution, the coating-resistance pattern unit 210 includes a heating roller 211 configured to heat the coating-resistance substance, so that the heated coating-resistance substance can be printed on the base film 230 more easily. In addition, the coating-resistance pattern unit 210 includes a pattern roller 212 with a pattern provided on the surface. In this way, when the base film 230 passes over the pattern roller 212, the heated coating-resistance substance can be printed on the base film 230 in the pattern on the pattern roller 212, so that the pattern formed on the partial area of the surface of the base film 230 is identical with the required pattern, thereby improving the accuracy of the pattern formed on the surface of the base film 230.

It is considered that in some cases, the coating-resistance substance on the pattern roller 212 may not be sufficiently printed on the base film 230 in the shape of the pattern. Therefore, in some embodiments, as shown in Fig. 3, the coating-resistance pattern unit 210 may further include a bottom roller 213. The bottom roller 213 and the pattern roller 212 are arranged side by side on two sides of the base film 230. When the base film 230 passes between the pattern roller 212 and the bottom roller 213, the coating-resistance substance on the pattern roller 212 is formed on a partial area of the surface of the base film 230 in pattern the shape of this pattern under the pressure between the pattern roller 212 and the bottom roller 213.

Optionally, the size of the bottom roller 213 may be larger than that of the pattern roller 212. As such, the bottom roller 213 can apply greater pressure to the pattern roller 212, so that the coating-resistance substance on the pattern roller 212 can be more sufficiently printed on the base film 230. Of course, as shown in Fig. 3, the size of the bottom roller 213 may also be the same as that of the pattern roller 212.

Alternatively, the size of the bottom roller 213 may be smaller than that of the pattern roller 212. In this case, in order to increase the pressure between the bottom roller 213 and the pattern roller 212, for example, there may be a plurality of bottom rollers 213. The plurality of bottom rollers 213 are all in contact with the pattern roller 212, and each bottom roller 213 may be in contact with a partial surface area of the pattern roller 212.

In the above technical solution, the coating-resistance pattern unit 210 includes a bottom roller 213 arranged side by side with the pattern roller 212 on two sides of the base film 230, so that the pattern roller 212 and the bottom roller 213 can exert pressure on each other. As such, when the base film 230 passes between the pattern roller 212 and the bottom roller, the pressure between the pattern roller 212 and the bottom roller 213 can cause the coating-resistance substance on the pattern roller 212 to be formed as much as possible on the surface of the base film 230 to ensure the accuracy of the coating.

Further, in some embodiments, as shown again in Fig. 3, the coating-resistance pattern unit 210 may further include an anilox roller 214. The anilox roller 214 is arranged between the heating roller 211 and the pattern roller 212. The surface of the anilox roller 214 is provided with a plurality of pits. The pits are used to store the heated coating-resistance substance. The anilox roller 214 is used to transfer the stored heated coating-resistance substance to the pattern roller 212.

Optionally, after the heating roller 211 heats the coating-resistance substance, the heated coating-resistance substance can be transferred to the anilox roller 214 by evaporation. Afterwards, the anilox roller 214 transfers the stored heated coating-resistance substance to the pattern roller 212 also by evaporation.

As for the specific structure of the anilox roller 214, reference may be made to the anilox roller in the related art, and no discussion will be made thereof in detail herein.

In the above technical solution, by arranging an anilox roller 214 between the heating roller 211 and the pattern roller 212, the heated coating-resistance substance can be evenly stored in the plurality of pits on the surface of the anilox roller 214. In this way, when the anilox roller 214 transfers the coating-resistance substance to the pattern roller 212, it can also transfer the coating-resistance substance to the pattern roller 212 evenly, which avoids the case where part of the surface of the pattern roller 212 receives more coating-resistance substance and part of the surface receives less or even no coating-resistance substance, thereby ensuring the accuracy of the pattern printed on the base film 230.

As mentioned earlier, some application scenarios require thicker metal coatings. The thicker the metal coating, the higher the heat the base film 230 endures. For example, the temperature of the base film 230 may reach two to three hundred degrees, which may cause deformation of the base film 230.

Based on this, as shown in Fig. 4, the coating apparatus 200 in the embodiments of the present application may further include a cooling unit 240. The cooling unit 240 is used to cool the base film 230 with the pattern after the pattern is formed on the partial area of the surface of the base film 230.

By providing the cooling unit 240, when the metal coating has a large thickness and the base film 230 endures a high amount of heat, the cooling unit 240 can cool the base film 230, thereby avoiding the problem of deformation of the base film 230 at high temperatures, and effectively ensuring the normal progress of the coating and subsequent processes.

In some embodiments, as shown in Fig. 4, the cooling unit 240 may include a cold drum 241 for transferring and cooling the base film 230 with the pattern. The cold drum 241 is configured as a hollow structure, and the hollow structure contains a cooling liquid to cool the base film 230 with the pattern in the process of circulation.

Optionally, the cold drum 241 may be a carbon steel roller or a stainless steel roller, or the like.

Optionally, the diameter of the cold drum 241 may be in the range of 300mm-600mm.

Optionally, the cooling liquid may be water, a mixture of water and ethylene glycol, or the like, or the cooling liquid may be at least one of liquid nitrogen, liquid argon, and liquid carbon dioxide.

When the vacuum coating mechanism 221 delivers metal vapor to the base film 230, heat will be released when the metal vapor becomes solid, so the heat that the base film 230 endures in this process will become higher. Therefore, as shown in Fig. 4, the cold drum 241 may be arranged above the vacuum coating mechanism 221, and while the vacuum coating mechanism 221 is configured to deliver metal vapor toward the base film 230 on the cold drum 241, the cold drum 241 can cool the base film 230 to ensure that the temperature of the base film 230 is within a normal range.

It is to be noted that the term "up" in the embodiments of the present application refers to the direction opposite to the direction of gravity, and the term "down" refers to the direction of gravity.

In the above technical solution, the base film 230 is cooled by the cold drum 241, which is easy to implement. Moreover, the cold drum 241 is provided with a circulating cooling liquid, and better cooling effect can be achieved through the circulation of the cooling liquid. That is, the embodiments of the present application can achieve better cooling effect in a simpler manner.

Since the base film 230 itself may be electrically conductive, in order to avoid electric conduction between the base film 230 and the cold drum 241, the surface of the cold drum 241 may further be coated with an insulating material.

Optionally, the insulating material may be ceramic, rubber, insulating paint, asbestos, or the like.

Optionally, the thickness of the insulating material may be in the range of 50um-2000um.

The above technical solution can avoid the problem of electric conduction between the cold drum 241 and the base film 230 by coating the surface of the cold drum 241 with the insulating material, thereby effectively ensuring the normal progress of the coating.

In some cases, the base film 230 and the cold drum 241 may not be completely adhered to each other, thus causing the cooling effect of the cold drum 241 on the base film 230 to be greatly reduced. Therefore, in some embodiments, the cooling unit 240 may also include a bias roller 242. The bias roller 242 is arranged downstream of the cold drum 241 in the transferring direction of the base film 230 to adsorb the base film 230 with the pattern to the surface of the cold drum 241.

As an example, the cold drum 241 can be grounded and the bias roller 242 can be connected to a negative voltage. For example, the bias roller 242 can be connected to a negative voltage of 50V-500V.

As another example, the cold drum 241 can be connected to a negative voltage and the bias roller 242 can be grounded.

In the case where the bias roller 242 is provided, optionally, the thickness of the insulating material may be 30um-200um. In this way, the thermal conduction effect and the bias effect can be balanced.

The above technical solution strengthens the adhesion between the base film 230 and the cold drum 241 by providing the bias roller 242, thereby improving the cooling effect of the coolant in the cold drum 241 on the base film 230. That is, the above technical solution effectively enhances the cooling effect on the base film 230 through the cooperation of the cold drum 241 and the bias roller 242.

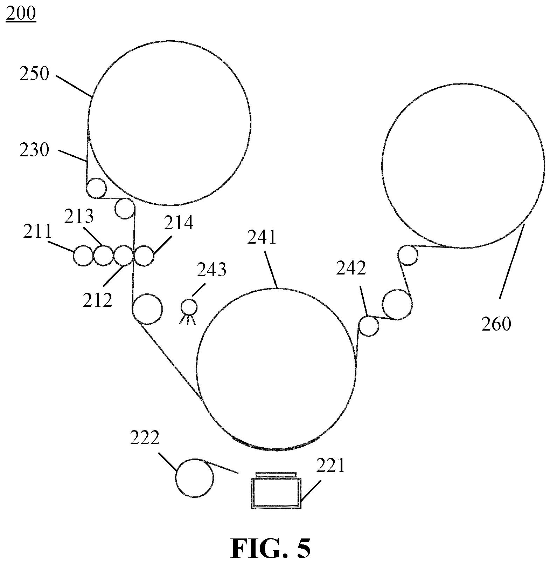

In order to further improve the cooling effect of the cooling unit 240 on the base film 230, further, as shown in Fig. 5, the cooling unit 240 may further include a gas cooling tube 243. The gas cooling tube 243 includes a heat-conducting medium which is introduced by the gas cooling tube 243 through a gas port to a position between the cold drum 241 and the base film 230 with the pattern, so that the heat-conducting medium cools the base film 230 with the pattern.

Specifically, the heat-conducting medium can be passed between the cold drum 241 and the base film 230 in a vacuum environment as a heat-conducting medium between the film and the cold drum 241 to cool the base film 230.

Optionally, the heat-conducting medium may be an inert gas, such as argon, helium, etc. For example, the density of the inert gas may be 1-5/100mm, and the range of flow may be from the flow value of 10 standard liters per minute (sccm) to 200sccm.

It should be understood that the specific examples herein are intended only to assist those skilled in the art to better understand the embodiments of the present application and are not intended to limit the scope of the embodiments of the present application.

Because the inert gas is relatively cheap, the cooling of the base film 230 can be effectively realized at a low cost by using the inert gas for cooling.

Optionally, the gas cooling tube 243 may include a plurality of gas ports. Each of the plurality of gas ports can cover the width of the base film 230, or the entirety of plurality of gas ports can cover the width of the base film 230. In the embodiment of the present application, the width of the base film 230 may also be referred to as the breadth.

For example, the number of gas ports may be determined based on the breadth.

In some implementations, the gas cooling tube 243 can continuously eject heat-conducting medium.

In other implementations, the coating apparatus 200 may include a control system. When the base film 230 with the pattern is transferred to the position of the cold drum 241, the control system can control the gas port of the gas cooling tube 243 to open, so that the heat-conducting medium is introduced by the gas cooling tube 243 through a gas port to a position between the cold drum 241 and the base film 230. At other times, the control system can control the gas port of the gas cooling tube 243 to close, thereby saving the heat-conducting medium and reducing the cost of cooling the base film 230.

In the above technical solution, the cooling unit 240 is further provided with a gas cooling tube 243 in addition to the cold drum 241, that is, the base film 230 is cooled jointly by the cold drum 241 and the gas cooling tube 243, which can further enhance the cooling effect on the base film 230.

It should be understood that the cooling unit 240 of the embodiment of the present application may include a gas cooling tube 243 and not the cold drum 241 and the bias roller 242. Alternatively, the cooling unit 240 may include the gas cooling tube 243 and the bias roller 242 without applying a negative voltage to the bias roller 242. In other words, in the embodiment of the present application, the base film 230 can be cooled only by the gas cooling tube 243.

Further, as can be seen from Figs. 2 to 5, the coating apparatus 200 in the embodiment of the present application may be a roll-to-roll coating apparatus. In addition to the coating-resistance pattern unit 210 and the coating unit 220, the coating apparatus 200 may also include an unwinding roller 250 and a winding roller 260.

The unwinding roller 250 is arranged at the most upstream of the transferring direction of the base film 230 to convey the base film 230 along the transferring direction. The winding roller 260 is arranged at the most downstream in the transferring direction to collect the coated base film 230.

Further, the coating apparatus 200 may further include at least one transfer roller to transfer the base film 230 to the coating-resistance pattern unit 210 and the cooling unit 24 along the transferring direction.

If the coating apparatus 200 includes a plurality of transfer rollers, the sizes of the plurality transfer rollers may be the same or different, which is not limited in the embodiments of the present application.

Although the present application has been described with reference to the preferred embodiments, various improvements can be made thereto and components thereof can be replaced with equivalents without departing from the scope of the present application. In particular, the technical features mentioned in the various embodiments can be combined in any manner as long as there is no structural conflict. The present application is not limited to the specific embodiments disclosed herein, but rather includes all technical solutions falling within the scope of the claims.

## Claims

1. A coating apparatus, comprising:
a coating-resistance pattern unit (210) configured to form a pattern composed of a coating-resistance substance on a partial area of the surface of the base film (230), the coating-resistance substance being used to restrict metal vapor from forming a coating; and
a coating unit (220) configured to apply the metal vapor to the base film (230) with the pattern, so as to form a metal coating on the area of the surface of the base film (230) where the coating-resistance substance is not provided.

2. The coating apparatus according to claim 1, wherein the coating-resistance pattern unit (210) comprises:
a heating roller (211) configured to heat the coating-resistance substance; and
a pattern roller (212) with the pattern provided on the surface to print the heated coating-resistance substance on the base film (230) in the shape of the pattern when the base film (230) passes over the pattern roller (212), so as to form the pattern on the partial area of the surface of the base film (230).

3. The coating apparatus according to claim 2, wherein the coating-resistance pattern unit (210) further comprises:
a bottom roller (213) arranged side by side with the pattern roller (212) on two sides of the base film (230), where when the base film (230) passes between the pattern roller (212) and the bottom roller (213), the coating-resistance substance on the pattern roller (212) is formed on the partial area of the surface of the base film (230) in the shape of the pattern under the pressure between the pattern roller (212) and the bottom roller (213).

4. The coating apparatus according to claim 2 or 3, wherein the coating-resistance pattern unit (210) further comprises:
an anilox roller (214) arranged between the heating roller (211) and the pattern roller (212), where the surface of the anilox roller (214) is provided with a plurality of pits, the pits are used to store the heated coating-resistance substance, and the anilox roller (214) is used to transfer the stored heated coating-resistance substance to the pattern roller (212).

5. The coating apparatus according to any one of claims 2 to 4, wherein the pattern roller (212) is a roller made of rubber.

6. The coating apparatus according to any one of claims 1 to 5, further comprising:
a cooling unit (240) configured to cool the base film (230) with the pattern after the pattern is formed on the partial area of the surface of the base film (230).

7. The coating apparatus according to claim 6, wherein the cooling unit (240) comprises:
a cold drum (241) configured to transfer and cool the base film (230) with the pattern, where the cold drum (241) is provided as a hollow structure, and the hollow structure contains a cooling liquid to cool the base film (230) with the pattern in the process of circulation.

8. The coating apparatus according to claim 7, wherein the surface of the cold drum (241) is coated with an insulating material.

9. The coating apparatus according to claim 8, wherein the thickness of the insulating material is 30um-200um.

10. The coating apparatus according to any one of claims 7 to 9, wherein the cooling unit (240) further comprises:
a bias roller (242) arranged downstream of the cold drum (241) in the transferring direction of the base film (230) to adsorb the base film (230) with the pattern to the surface of the cold drum (241).

11. The coating apparatus according to claim 10, wherein the cold drum (241) is grounded and the bias roller (242) is connected to a negative voltage.

12. The coating apparatus according to any one of claims 7 to 11, wherein the cooling unit (240) further comprises:
a gas cooling tube (243) including a heat-conducting medium which is introduced by the gas cooling tube (243) through a gas port to a position between the cold drum (241) and the base film (230) with the pattern, so that the heat-conducting medium cools the base film (230) with the pattern.

13. The coating apparatus according to claim 12, wherein the heat-conducting medium is an inert gas.

14. The coating apparatus according to any one of claims 7 to 13, wherein the coating unit (220) comprises a vacuum coating mechanism (221) configured to deliver metal vapor toward the base film (230) on the cold drum (241).

15. The coating apparatus according to any one of claims 1 to 14, wherein the coating-resistance substance is silicone oil.

16. The coating apparatus according to any one of claims 1 to 15, wherein the thickness of the metal coating is 1um-3um.

17. The coating apparatus according to any one of claims 1 to 16, wherein the base film (230) is a polyethylene terephthalate PET film.

18. The coating apparatus according to any one of claims 1 to 17, wherein the metal vapor is copper vapor or aluminum vapor.
